# EUROPÄISCHE PATENTSCHRIFT

(11) **EP 1 806 352 B1**
(45) Veröffentlichungstag und Bekanntmachung des Hinweises auf die Patenterteilung: **29.12.2010**
(21) Anmeldenummer: 07000051.8
(22) Anmeldetag: 03.01.2007
(51) Int. Cl.: C07F 11/00, C23C 16/18

(54) **Wolfram- und Molybdän-Verbindungen und ihre Verwendung für die Chemical Vapour Deposition (CVD)**
Tungsten and molybdenum compounds and their application for Chemical Vapour Deposition (CVD)
Liaisons de tungstène et molybdène et son utilisation dans le dépôt chimique en phase vapeur

(30) Priorität: 05.01.2006 DE 102006000823
(43) Veröffentlichungstag der Anmeldung: 11.07.2007
(73) Patentinhaber: H.C. Starck Clevios GmbH, 38642 Goslar (DE)
(72) Erfinder: Reuter, Knud, Dr., 47800 Krefeld (DE); Sundermeyer, Jörg, Prof. Dr., 35041 Marburg (DE); Merkoulov, Alexei, 127322 Moskau (RU); Stolz, Wolfgang, Dr., 35041 Marburg (DE); Volz, Kerstin, 35232 Dautphetal (DE); Pokoj, Michael, 35463 Fernwald (DE); Ochs, Thomas, 35274 Kirchheim-Betziesdorf (DE)
(74) Vertreter: Herzog, Martin

(56) Entgegenhaltungen:
- WO-A-2004/007796

## Beschreibung

Die vorliegende Erfindung betrifft spezielle, neue Wolfram- und Molybdänverbindungen, deren Verwendung zur Abscheidung Wolfram- bzw. Molybdänhaltiger Schichten mittels Chemical Vapor Deposition sowie die gemäß diesem Verfahren hergestellten Wolfram- bzw. Molybdänhaltigen Schichten.

Wolfromnitrid ist ein vielversprechendes Material für Barriereschichten in integrierten Schaltkreisen mit Kupfer-Leiterbahnen, z. B. wegen seiner Widerstandsfähigkeit, seiner exzellenten thermisehen, chemischen und mechanischen Beständigkeit. Seine elektrische Leitfühigkeit ist hoch, und es bildet keine Mischphasen mit Kupfer. Solche W-N-basierenden Schichten für die Anwendung in der Si-Mikroclektronik können gegenwärtig durch plasmabasierende Abscheidevorfahren (Physical Vapour Deposition, PVD) hergestellt werden. Im Hinblick auf die extremen Anforderungen für immer höher integrierte Schaltkreise, z.B. der konformen Schichlabscheidung auf strukturierten Oberflächen ("step coverage"), stoßen PVD-Verfahren jedoch an die Grenzen der technischen Realieierbarkeit. Für diese Anwendungen worden verstärkt chemische Gasphasenabscheidungen (Chemical Vapour Deposition, CVD) bis hin zur atomlagen-genauen Abscheidung mit einem Spezialverfahren der CVD, der sogenannten Atomic Layer Deposition (ALD), eingesetzt. Für diese CVD-Verfahren müssen naturgemäß für die jeweiligen gewünschten Schichten entsprechende chemische Ausgangsstoffe der einzelnen Elemente zur Verfügung stehen.

Zum gegenwärtigen Zeitpunkt werden für die CVD W-basierender Schichtstrukturen vorwiegend Halogenide verwendet, wie z.B. WF₆ oder WCl₆, siehe z. B. J. P. I.u, W. Y. Hsu, J. D. Luttmer, L. K Magel und H. L. Tsai, J. Electrochem Soc 145 (1998), L21- L23, oder A. E. Kaloyeros und E. Eisenbraun, Annu. Rev Mater Sci. 30 (2000), 363 - 385 Dies ist mit verschiedenen Nachteilen behaftet Zum einen sind Halogenrudikale vielfach aufgrund ihrer ätzenden/korrodierenden Eigenschaften für den Aufbau komplexer Schichtstrukturen unerwünscht, andererseits hat Wolframfluorid Nachteile durch die geringe Flüchtigkeit und hohe Abscheidetemperatur. Wolfram(VI)-amidimide, wie z.B. (^{t}BuN=)₂W(NH¹Bu)_{z} (siehe H. T. Chiu und S. H. Chuang, J Mater Res. 8 (1993), 1353) oder (^{t}BuN=)₂W(NMe)₃ oder (^{t}BuN=)₂W(NMeEt)₂ (siehe J. S. Becker, S. Suh, S. Wang und R. G. Gordon, Chem Mater. 15 (2003), 2969 - 2976 oder WO 2004/007796) werden ebenfalls vorgeschlagen. Die mit diesen Ausgangsstoffen hergestellten Filme enthalten sehr oft hohe, unerwünschte Konzentrationen an Kohlenstoff und zeigen eine relativ geringe Leitfähigkeit.

Somit besteht ein erheblicher Bedarf nach weiteren, neuen Prekursoren, insbesondere für WN-Schichten, die die vorgenannten Nachteile nicht aufweisen oder zumindest deutliche Verbesserungen gegenüber den bekannten Prekursoren bewirken.

Somit bestand die Aufgabe, die der vorliegenden Erfindung zugrunde lag, darin, solche Precursoren bereitzustellen.

Überraschend wurde nun gefunden, dass komplexe Wolframamide mit einem DAD-Liganden diese Voraussetzungen erfüllen. DAD steht für vom 1,4-Diaza-butadien abgeleitete Reste der allgemeinen Struktur (A) 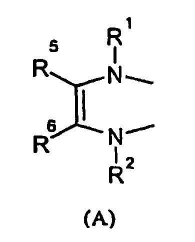 wobei
- R¹ und R²: unabhängig voneinander gegebenenfalls substituierte C₁- bis C₁₂-Alkyl-, C₅- bis C₁₂-Cycloalkyl-, C₆- bis C₁₀-Aryl-Reste, 1-Alkenyl-, 2-Alkenyl-, 3-Alkenylreste, Triorganosilylreste -SiR₃ oder Aminoreste NR₂ stehen, worin R für einen C₁- bis C₄-Alkylrest steht,
- R⁵ und R⁶: unabhängig voneinander H, gegebenenfalls substituierte C₁-bis C₁₂-Alkyl-, C₅- bis C₁₂-Cycloalkyl- oder C₆- bis C₁₀-Aryl-Reste bedeuten.

Die Erfindung betrifft weiterhin die analogen Molybdän-Verbindungen. Diese eignen sich z. B. als CVD-Prekursoren für leitfähige Molybdän-Nitrid-Schichten (MoN).

Gegenstand der Erfindung sind daher Verbindungen der allgemeinen Formel (I), 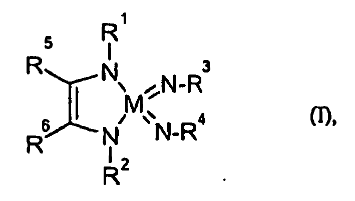 wobei
- M: für Mo oder W steht,
- R¹ und: R¹ unabhängig voneinander für einen gegebenenfalls substituierten C₁- bis C₁₂-Alkyl-, C₅- bis C₁₂-Cycloalkyl-, C₆- bis C₁₀-Azyl-Reste, 1-Alkenyl-, 2-Alkenyl-, 3-Alkenylreste, Trior- ganosilylreste -SiR₃ oder Aminoreste NR₂ stehen, worin R für einen C₁- bis C₄-Alkylrest steht,
- R³ und R⁴: unabhängig voneinander für einen gegebenenfalls substituierten C₁- bis C₈-Alkyl-, C₅- bis C₁₀-Cycloalkyl-, C₆- bis C₁₄-Aryl-Rest, SiR₃ oder NR₂ stehen, wobei R die oben ge- nannte Bedeutung hat, und
- R⁵ und R⁶: unabhängig voneinander für H oder einen gegebenenfalls substituierten C₁- bis C₁₂- Alkyl-, C₅- bis C₁₂-Cycloalkyl- oder C₆- bis C₁₀-Aryl-Rest stehen.

Unter substituiert wird hier, wenn nicht anders erwähnt, eine Substitution mit C₁- bis C₄-Alkoxy-oder Di(C₁-bis C₄-Alkyl)-amino-Resten verstanden.

Bevorzugte erfindungsgemäße Verbindungen der allgemeinen Formel (I) sind Wolfram- und Molybdänverbindungen der allgemeinen Formel (II), 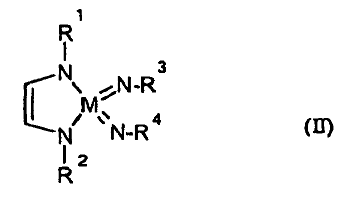 wobei
- M: für W oder Mo steht,
- R¹ und R²: gleiche C₁- bis C₅-Alkyl- oder C₅- bis C₆-Cycloalkyl-Reste, und
- R³ und R⁴: unabhängig voneinander einen C₁- bis C₅-Alkylrest, einen C₅- bis C₆-Cycloalkylrest, einen gegebenenfalls durch eine bis drei C₁ bis C₅-Alkylgruppen substituierten C₆- C₁₀- Arylrest - bevorzugt gegebenenfalls substituierten Phenyl-Rest - SiR₃ oder NR₂, wobei R für C₁-C₄-Alkyl steht, bedeuten.

Besonders bevorzugt sind dies Wolfram- und Molybdänverbindungen mit tert-Butyl-substituierten DAD-Liganden, welche die Struktur (III) aufweisen: 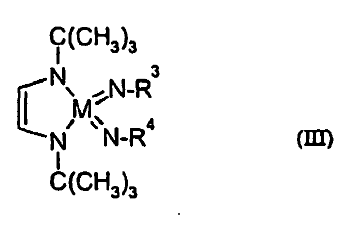 wobei
R³ und R⁴ unabhängig voneinander für einen Rest aus der Gruppe der C₁- bis C₅-Alkylreste, gegebenenfalls durch eine bis drei C₁- bis C₅-Alkylgruppen substituierte C₆- C₁₀-Arylreste - bevorzugt gegebenenfalls substituierten Phenyl-Reste - SiR₃ oder NR₂ stehen.

Ganz besonders bevorzugt sind dies Verbindungen der Struktur (IV) 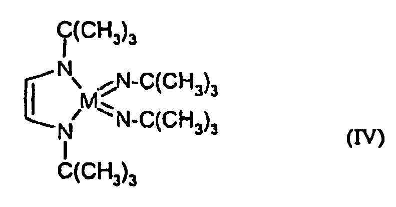 wobei M für W oder Mo steht.

**Alkyl** beziehungsweise **Alkoxy** steht jeweils unabhängig für einen geradkettigen, cyclischen oder verzweigten Alkyl- beziehungsweise Alkoxy-Rest, wobei die genannten Reste gegebenenfalls weiter substituiert sein können. Gleiches gilt für den Alkylteil eines Trialkylsilyl- bzw. Mono- oder Dialkylaminorestes oder den Alkylteil von Mono- oder Dialkylhydranzinen oder Mono-, Di-, Tri-oder Tetraalkylsilanen.

**C₁-C₄-Alkyl** steht im Rahmen der Erfindung beispielsweise für Methyl, Ethyl, n-Propyl, isoPropyl, n-Butyl, sec.-Butyl, tert.-Butyl, C₁-C₅-Alkyl darüber hinaus beispielsweise für n-Pentyl, 1-Methylbutyl, 2-Methylbutyl, 3-Methylbutyl, neo-Pentyl, 1-Ethylpropyl, 1,1-Dimethylpropyl, 1,2-Dimethylpropyl, 1,2-Dimethylpropyl, C₁-C₆-Alkyl darüber hinaus beispielsweise für n-Hexyl, 1-Methylpentyl, 2-Methylpentyl, 3-Methylpentyl, 4-Methylpentyl, 1,1-Dimethylbutyl, 1,2-Dimethylbutyl, 1,3-Dimethylbutyl, 2,2-Dimethylbutyl, 2,3-Dimethylbutyl, 3,3-Dimethylbutyl, 1-Ethylbutyl, 2-Ethylbutyl, 1,1,2-Trimethylpropyl, 1,2,2-Trimethylpropyl, 1-Ethyl-1-methylpropyl, 1-Ethyl-2-methylpropyl oder 1-Ethyl-2-methylpropyl, C₁-C₁₂-Alkyl darüber hinaus beispielsweise für n-Heptyl und n-Octyl, n-Nonyl, n-Decyl und n-Dodecyl.

**1-Alkenyl, 2-Alkenyl, 3-Alkenyl** steht beispielsweise für die den vorangehenden Alkylgruppen entsprechenden Alkenylgruppen. C₁-C₄-Alkoxy steht beispielsweise für die den vorangehenden Alkylgruppen entsprechenden Alkoxygruppen, wie z.B. Methoxy, Ethoxy, n-Propoxy, iso-Propoxy, n-Butoxy, sec.-Butoxy, tert.-Butoxy.

**C₅-C₁₂-Cycloalkyl** steht beispielsweise für gegebenenfalls substituierte mono-, bi- oder tricylische Alkylreste. Als Beispiele seien Cylopentyl, Cyclohexyl, Cycloheptyl, Pinanyl, Adamantyl, die isomeren Menthyle, n-Nonyl, n-Decyl, n-Dodecyl. Bevorzugt als C₅-C₆-Cycloalkyl sind Cylopentyl und Cyclohexyl.

**Aryl** steht jeweils unabhängig für einen aromatischen Rest mit 6 bis 14, bevorzugt 6 bis 10 Gerüstkohlenstoffatomen, in denen keines, ein, zwei oder drei Gerüstkohlenstoffatome pro Cyclus durch Heteroatome, ausgewählt aus der Gruppe Stickstoff, Schwefel oder Sauerstoff, substituiert sein können, vorzugsweise jedoch für einen carbocyclischen aromatischen Rest mit 6 bis 14, bevorzugt 6 bis 10 Gerüstkohlenstoffatomen.

Beispiele für gegebenenfalls substituierte **C₆-C₁₀-Aryl** sind Phenyl, 2,6-Diisopropylphenyl, o-, p-, m-Tolyl oder Naphthyl.

Weiterhin kann der carbocyclische aromatische Rest oder heteroaromatische Rest mit bis zu fünf gleichen oder verschiedenen Substituenten pro Cyclus substituiert sein, die ausgewählt sind aus der Gruppe Fluor, Cyano, C₁-C₁₂-Alkyl, C₁-C₁₂-Fluoralkyl, C₁-C₁₂-Fluoralkoxy, C₁-C₁₂-Alkoxy oder Di(C₁-C₈-alkyl)amino.

Die erfindungsgemäßen Verbindungen können auf einfache Weise hergestellt werden, indem DAD-Ligandenvorläufer der allgemeinen Formel (B) 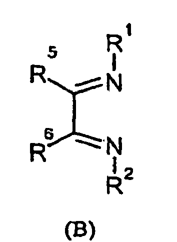 worin R¹, R², R⁵ und R⁶ die vorangehend genannte Bedeutung haben,

in Gegenwart wenigstens eines Reduktionsmittels mit Mo- oder W-Komplexen der allgemeinen Formel (C),

[M(NR³)(NR⁴)Cl₂L₂]

worin
- M: für W oder Mo steht
- L: für einen Liganden ausgewählt aus aliphatischen oder aromatischen Aminen, Ethern, Halogenid, bevorzugt Chlorid, oder Nitrilen, bevorzugt Acetonitril,
- R³ oder R⁴: die vorangehend genannte Bedeutung haben,
in einem geeigneten Lösungsmittel bevorzugt bei einer Temperatur von -20°C bis 120°C umgesetzt werden.

Als geeignete Reduktionsmittel kommen unedle Metalle wie z.B. Mg, Zn, Li, Na, Al etc. in Frage. Geeignete Lösungsmittel sind beispielsweise Ether, wie z.B. THF, Diethylether oder 1,2-Dimethoxyethan, dipolar-aprotische Lösungsmittel, wie z.B. Acetonitril, N,N-Dimethylformamid oder tert.-Amine oder aliphatische oder aromatische Kohlenwasserstoffe, wie z.B. Toluol, Pentan, Hexan, etc., sowie Mischungen aus diesen. Die Mo- oder W-Komplexe der allgemeinen Formel (C) [M(NR³)(NR⁴)Cl₂L₂] sind nach allgemein bekannten Verfahren in isolierter Form oder in-situ herstellbar.

Darüber hinaus ist es auch möglich, den DAD-Ligandenvorläufer der allgemeinen Formel (B) vorab in einem geeigneten Lösungsmittel mit dem Reduktionsmittel zu reduzieren, so dass Lösungen der vorreduzierten DAD-Liganden, wie z.B. bei Verwendung von Li als Reduktionsmittel Li[DAD] oder Li₂[DAD], mit der Lösung der Komplexe der allgemeinen Formel (C) umgesetzt werden. Bei sorgfältiger Wahl und Kontrolle der Reaktionstemperatur zwischen -20°C und 120°C ist es auch möglich, die erfindungsgemäßen Verbindungen in einer Eintopfsynthese herzustellen, bei der z.B. WCl₆ mit dem oder den Amin(en) H₂NR³ oder H₂NR⁴, dem Reduktionsmittel und dem DAD-Ligandenvorläufer der allgemeinen Formel (B) zusammengegeben und zur Reaktion gebracht wird.

Zur Isolation der erfindungsgemäßen Verbindungen wird das Lösungsmittel beispielsweise mittels Abdestillieren unter vermindertem Druck entfernt, und es kann sich eine weitere Reinigung mittels Waschen sowie eine nachfolgende Trocknung anschließen. Solche geeigneten Verfahren sind dem Fachmann bekannt.

Aus den erfindungsgemäßen Wolfram- und Molybdänverbindungen können Wolfram- und/oder Molybdän-haltige Metalle, Metalllegierungen, Oxide, Nitride und Carbide, sowie deren Mischungen und/oder Verbindungen in amorpher und/oder kristalliner Form, mittels CVD, ALD (Atomic Layer Deposition) und thermischer Zersetzung erzeugt werden. Anwendung finden derartige Mischungen und Verbindungen z. B. als dielektrische Schichten in Kondensatoren und Gates in Transistoren, Mikrowellenkeramiken, Piezokeramiken, thermische und chemische Barriereschichten, Diffusionsbarriereschichten, Hartstoffbeschichtungen, elektrisch leitfähigen Schichten, Antireflektionsschichten, optische Schichten und Schichten für IR-Spiegel. Auch als Prekursoren für Flammpyrolysen zur Herstellung von Pulvern sind die erfindungsgemäßen Wolfram- und Molybdänverbindungen geeignet.

Die Erfindung betrifft daher auch die Verwendung der erfindungsgemäßen Wolfram und Molybdänverbindungen zur Abscheidung Wolfram- bzw. Molybdän-haltiger Schichten gegebenenfalls unter Beimischung weiterer Verbindungen zur definierten Einstellung bestimmter Konzentrationen der jeweiligen Elemente in der Schicht mittels Chemical Vapour Deposition (CVD).

Bevorzugt ist die Verwendung der erfindungsgemäßen Verbindungen als Prekursoren für Wolframnitrid-(WN)-schichten oder Molybdännitridschichten mittels CVD.

Weiterhin Gegenstand der Erfindung sind die entsprechend aus den erfindungsgemäßen Verbindungen mittels CVD hergestellten Wolfram- bzw. Molybdän-haltigen Schichten, bevorzugt WN-oder MoN-Schichten.

Weiterhin Gegenstand der Erfindung sind Substrate, die eine oder mehrere solcher erfindungsgemäßen Wolfram- bzw. Molybdän-haltigen Schichten, bevorzugt WN- oder MoN-Schichten aufweisen. Solche Substrate können beispielsweise Silizium-Scheiben oder bereits weitere oberflächenstrukturierte Einzel- oder Mehrfachschichten aufweisende Silizium-Scheiben, wie sie typischerweise für die Herstellung von Si-basierenden integrierten Schaltkreisen eingesetzt werden. Demzufolge können Substrate im Rahmen der Erfindung beispielsweise auch Metall- oder Dielektrika-Oberflächen sein.

Bevorzugt werden die erfindungsgemäßen Verbindungen in einem CVD-Verfahren mit folgenden Verfahrensschritten eingesetzt:
Ein geeignetes Substrat, wie z.B. eine Si-Scheibe oder auch eine bereits weitere oberflächenstrukturierte Einzel- oder Mehrfachschichten aufweisende Si-Scheibe, wie sie typischerweise für die Herstellung von Si-basierenden integrierten Schaltkreisen eingesetzt werden, wird in eine CVD-Anlage eingebracht und auf eine für die Schichtabscheidung geeignete Temperatur im Bereich von 250 °C bis 700 °C aufgeheizt. Ein Trägergas wird mit den Edukten in definierten Konzentrationen beladen, wobei inerte Gase wie z.B. N₂ und/oder Ar, auch in Kombination mit inerten, verdampften Lösungsmitteln wie z.B. Hexan, Heptan, Octan, Toluol oder Butylacetat, als Trägergas eingesetzt werden können, und auch reaktive, z. B. reduzierende Gase, wie z. B. H₂, zugesetzt werden können. Das beladene Trägergas wird für eine definierte Expositionsdauer über die Oberfläche des aufgeheizten Substrates geleitet, wobei die jeweiligen Konzentrationen an Edukten und die Expositionsdauer mit der Maßgabe aufeinander abgestimmt sind, dass eine W- bzw. Mo-haltige Schicht mit einer vorgegebenen Schichtdicke und einer vorgegebenen Zusammensetzung auf der Oberfläche des Substrats entweder amorph, nano- oder mikrokristallin bzw. polykristallin gebildet wird. Typische Expositionsdauem sind je nach Abscheiderate beispielsweise wenige Sekunden bis hin zu mehreren Minuten oder Stunden. Typische Abscheideraten können beispielsweise von 0,1 nm/sec bis 1 nm/sec sein Es sind jedoch auch andere Abscheideraten möglich. Typische Schichtdicken sind beispielsweise 0,1 bis 100 nm, bevorzugt 0,5 bis 50 nm, besonders bevorzugt 1 bis 10 nm.

Vorteilhafterweise werden im Rahmen der CVD-Technologie neben den Edukten gemäß allgemeiner Formel (I), bevorzugt der allgemeinen Formeln (II) bis (IV), zur Herstellung von reinen W-bzw. Mo-Metallschichten, W- bzw. Mo-reichen Schichten als auch W-N- bzw. Mo-N-haltigen Mischschichten auch die folgenden Edukte zur gezielten Einstellung der Stickstoffkonzentration (N-Konzentration) von W-N- bzw. Mo-N-haltigen Mischsystemschichten - auch nachfolgend N-Edukte genannt - eingesetzt:
Ammoniak (NH₃), Mono(C₁-C₁₂-alkyl)hydrazine, insbesondere *tert*.Butylhydrazin (^{t}Bu-NH-NH₂), und/oder 1,1-Di(C₁-C₅-alkyl)hydrazine, insbesondere 1,1-Dimethylhydrazin ((CH₃)₂N-NH₂). Insbesondere zur Beeinflussung der Stabilität der hergestellten Mischsystemschichten in nachfolgenden Hochtemperaturausheizschritten kann es günstig sein, weitere Elemente in der CVD-Abscheidung beizumischen, um das Rekristallisationsverhalten der gebildeten Schicht zu beeinflussen. Für die Anwendung in Si-basierenden integrierten Schaltkreisen kommt hierfür besonders das Element Silizium (Si) in Frage. Vorteilhafterweise werden für die Herstellung von W-N-Si-oder Mo-N-Si-haltigen Mischsystemschichten neben den oben angesprochenen Edukten die folgenden Edukte für die Einstellung der Siliziumkonzentration - auch nachfolgend Si-Edukte genannt - in der CVD-Technologie eingesetzt:
   Silan (SiH₄), Disilan (Si₂H₆), Mono(C₁-C₁₂-alkyl)silane, insbesondere *tert*.Butylsilan (tBu-SiH₃), Di(C₁-C₁₂-alkyl)silane, insbesondere Di-*tert.*butylsilan (tBu₂SiH₂), Tri(C₁-C₁₂-alkyl)silane, insbesondere Triethylsilan ((C₂H₅)₃SiH), und/oder Tetra(C₁-C₁₂-alkyl)silane, insbesondere Tetraethylsilan ((C₂H₅)₄Si ).

Bei der Durchführung des erfindungsgemäßen Verfahrens richten sich die genauen Konzentrationen der Edukte grundsätzlich nach den thermischen Zerlegungseigenschaften der jeweiligen Edukte im CVD-Prozess. Vorzugsweise werden die Edukte in folgenden Mol-Verhältnissen eingesetzt: N-Edukt(e)/erfindungsgemäße W- bzw. Mo-Verbindung in Verhältnissen von 0 : 1 bis 20 000 : 1 und Si-Edukt(e)/ erfindungsgemäße W- bzw. Mo-Edukt in Verhältnissen von 0 : 1 bis 100 : 1. Die Oberflächentemperatur des Substrats wird bevorzugt auf Temperaturen im Bereich von 300 °C. bis 600 °C eingestellt. Der Gesamtdruck von Trägergas und Edukten wird bevorzugt auf Drücke im Bereich von 10 hPa bis 1000 hPa eingestellt, wobei das Verhältnis des Partialdrucks der Summe aller Edukte zum Partialdruck des Trägergases bevorzugt zwischen 0,0001 bis 0,5 liegt. Die Abscheiderate beträgt bevorzugt 0,05 nm/min bis 50 nm/min.

Als technische Vorteile der vorliegenden Erfindung sind die folgenden Punkte anzusehen:
1) Die Synthese der flüchtigen Wolfram- und Molybdänvrbindungen verzichtet auf teure Lithiumalkyle oder -amide.
2) Die Einführung des DAD-Liganden als CVD-geeignete Abgangsgruppe für W(III)- oder Mo(III)-Schichten reduziert die Gefahr eines unerwünschten Kohlensoff-Einbaus in die Substratbeschichtung.
3) In der Kombination mit N-Edukten, beispielsweise mit Hydrazin-Derivaten (z.B. 1,1-Dimethylhydrazin oder tert.-Butylhydrazin), ist bei der CVD eine gezielte Veränderung der Schicht-Zusammensetzung möglich.

Die folgenden Beispiele dienen der beispielhaften Erläuterung der Erfindung und sind nicht als Beschränkung aufzufassen.

### Beispiele

In den nachfolgenden Beispielen bedeuten die Abkürzungen und abgekürzten Verbindungsnamen folgende Strukturen:
- D^{t}BuAD =: 1,4-Di-tert.-butyl-1,4-diaza-butadien
- bzw. sein zweiwertiger Rest =: 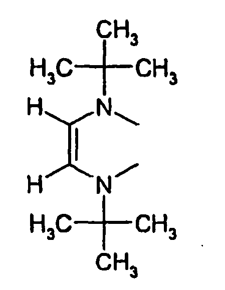
- ^{t}Bu =: tert. Butyl
- ^{t}BuN =: ^{t}Bu-N= tert.-Butylimino
- Py =: Pyridin
- DME =: Dimethoxyethan

### Beispiel 1:

### Darstellung von (D^{t}BuAD)Mo(N^{t}Bu)₂

1,69 g D^{t}BuAD (10,0 mmol) und 0,24 g Mg-Pulver (10,0 mmol) werden zu einer Lösung von 4,00 g Mo(N^{t}Bu)₂Cl₂(dme) (10,0 mmol) in 50 ml THF bei 0 °C zugegeben. Das Reaktionsgemisch wird 1 d bei 23 °C gerührt. Das Lösungsmittel wird danach bei 20 mbar abgezogen und das Produkt zweimal mit jeweils 100 ml Hexan extrahiert. Anschließend wird das Hexan abgedampft und der Rückstand bei 90 °C/10⁻² mbar sublimiert. Ausbeute: 2,44 g (60%), orangefarbener Feststoff; Schmp. 79 °C.

| | | | | |
|---|---|---|---|---|
| Elementaranalyse für C₁₈H₃₈N₄Mo (M = 406,47 g-mol⁻¹): | ber. (%) | C 53,19; | H 9,42; | N 13,78; |
| | gef. (%) | C 52,62; | H 9,35; | N 13,65. |

MS-EI: 408 (M⁺, 41 %), 393 (M⁺ - Me, 100 %), 352 (M⁺ - Me₂C=CH₂, 3 %), 337 (M⁺ - Me - Me₂C=CH₂, 23 %), 296 (M⁺ - 2 Me₂C=CH₂, 3 %), 281 (M⁺ - Me - 2 Me₂C=CH₂, 6 %).
¹H-NMR (C₆D₆, 300 MHz, 300 K): 6,05 (s, 2H, C*H*-DAD), 1,56 (s, 9H, N*^{t}Bu*), 1,33 (s, 18H, *^{t}Bu-*DAD), 1,26 (s, 9H, N*^{t}Bu*).
¹³C{¹H}-NMR (C₆D₆, 75 MHz, 300 K): 113,4 (CH-DAD), 66,7 und 65,9 (NC(CH₃)₃), 55,9 (C(CH₃)₃-DAD), 33,6 und 33,1 (NC(CH₃)₃), 32,0 (C(CH₃)₃-DAD).
IR (KBr, cm⁻¹): 3182 (w), 3010 (w), 1414 (w), 1361 (s), 1262 (w), 1246 (m), 1217 (s), 1120 (w), 1055 (w), 1021 (w), 936 (w), 875 (w), 814 (w), 805 (w), 773 (w), 724 (w), 673 (w), 638 (w), 605 (w), 581 (w), 551 (w), 518 (w), 470 (w).

### Beispiel 2:

### Darstellung von (D^{t}BuAD)W(N^{t}Bu)₂

610 mg D ^{t}BuAD (3,6 mmol) und 90 mg Mg-Pulver (3,7 mmol) werden zu einer Lösung von 2,00 g W(N^{t}Bu)₂Cl₂Py₂ (3,6 mmol) in 50 ml THF bei 0 °C zugegeben. Das Reaktionsgemisch wird 1 d bei RT gerührt. Das Lösungsmittel wird bei 20 mbar entfernt und das Produkt zweimal mit jeweils 100 ml Hexan extrahiert. Anschließend wird das Hexan abgedampft und der Rückstand bei 100 °C/10⁻² mbar sublimiert. Ausbeute: 590 mg (28%), orangegelber Feststoff; Schmp. 73,5 °C.

| | | | | |
|---|---|---|---|---|
| Elementaranalyse für C₁₈H₃₈N₄W (M = 494,38 g·mol⁻¹): | ber. (%) | C 43,73; | H 7,75; | N 11,33; |
| | gef. (%) | C 43,19; | H 7,72; | N 11,27. |

MS-EI: 494 (M⁺, 28 %), 479 (M⁺ - Me, 100 %), 438 (M⁺ - Me₂C=CH₂, 5 %), 423 (M⁺ - Me - Me₂C=CH₂, 9 %), 367 (M⁺ - Me - 2 Me₂C=CH₂, 3 %), 311 (M⁺ - Me - 3 Me₂C=CH₂, 4 %).
¹H-NMR (C₆D₆, 300 MHz, 300 K): 6,27 (s, 2H, C*H*-DAD), 1,89 (s, 9H, N*^{t}Bu*), 1,64 (s, 18H, *^{t}Bu-*DAD), 1,62 (s, 9H, N*^{t}Bu*).
¹³C{¹H}-NMR (C₆D₆, 75 MHz, 300 K): 109,2 (CH-DAD), 65,4 und 65,3 (NC(CH₃)₃), 56,3 (C(CH₃)₃-DAD), 34,3 und 34,1 (NC(*C*H₃)₃), 32,0 (C(*C*H₃)₃-DAD).
IR (KBr, cm⁻¹): 3026 (w), 1489 (w), 1402 (w), 1364 (m), 1354 (w), 1294 (m), 1248 (s), 1219 (s), 1163 (w), 1144 (w), 1113 (w), 1067 (w), 1026 (w), 972 (w), 872 (m), 814 (w), 808 (w), 774 (m), 721 (w), 660 (w), 598 (w), 673 (w), 544 (w), 519 (w), 476 (w).

## Patentansprüche

1. Verbindungen der allgemeinen Formel (I) 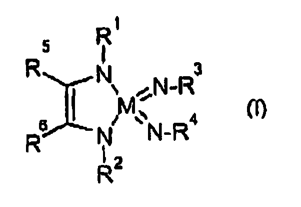 wobei
M für W oder Mo steht,
R¹ und R² unabhängig voneinander für einen C₁- bis C₁₂- Alkyl-, C₅- bis C₁₂-Cyoloalkyl-, C₆- bis C₁₀-Aryl-Reste, 1-Alkenyl-, 2-Alkenyl-, 3- Alkenylreste, Triorganosilylreste -SiR₃ oder Aminoreste NR₂ stehen, worin R für einen C₁- bis C₄-Alkylrest steht,
R³ und R⁴ unabhängig voneinander für einen C₁- bis C₈- Alkyl-, C₅- bis C₁₀-Cycloalkyl-, C₆- bis C₁₄-Aryl-Rest, SiR₃ oder NR₂ stehen, wo- bei R die oben genannte Bedeutung hat, und
R⁵ und R⁶ unabhängig voneinander für H oder einen C₁- bis C₁₂-Alkyl-, C₅- bis C₁₃-Cycloalkyl- oder C₆- bis C₁₀-Aryl-Rest stehen.

2. Verbindungen gemäß Anspruch 1, **dadurch gekennzeichnet, dass** R¹, R², R³, R⁴, R⁵ und R⁶ jeweils unabhängig voneinander mit einem C₁-C₄-Alkoxy- oder Di(C₁- C₄-Alkyl)aminorest substituiert sein kann.

3. Verbindungen nach Anspruch 1 oder 2 **dadurch gekennzeichnet, dass** sie der allgemeinen Formel (II) entsprechen, 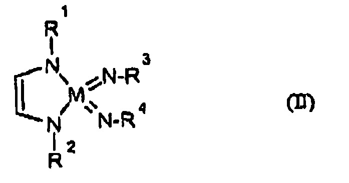 wobei
M, R¹ und R² die in Anspruch 1 genannte Bedeutung haben und
R³ und R⁴ unabhängig voneinander für einen C₁- bis C₅-Alkylrest, einen C₅- bis C₆- Cycloalkylrest, einen C₆- C₁₀-Arylrest, SiR₃ oder NR₃ stehen, wobei R für C₁-C₄-Alkyl steht

4. Verbindungen gemäß Anspruch 3, **dadurch gekennzeichnet, dass** der C₆-C₁₀ Arylrest in R³ und R⁸ durch eine bis drei C₁-C₅-Alkylgruppen substituiert sein kann.

5. Verbindungen nach wenigsten einem+ der Ansprüche 1 bis 4 **dadurch gekennzeichnet, dass** sie der allgemeinen Formel (III) entsprechen, 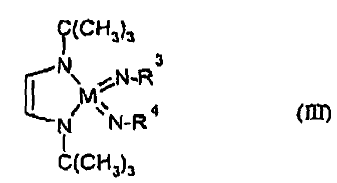 wobei M, R³ und R⁴ die in den Ansprüchen 1 bis 4 genannte Bedeutung haben.

6. Verbundungen nach wenigstens einem der Ansprüche 1 bis 5, **dadurch gekennzeichnet, dass** sie der allgemeinen Formel (IV) entsprechen, 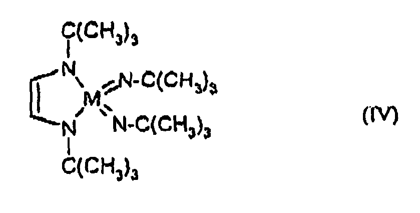 wobei M die in Anspruch 1 genannte Bedeutung hat

7. Verfahren zur Herstellung von Verbindungen gemäß den Ansprüchen 1 bis 6, **dadurch gekennzeichnet, dass** DAD-Ligandenvorläufer der allgemeinen Formel (B) 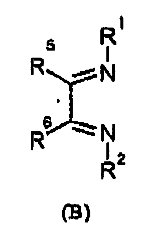 worin R¹, R², R⁵ und R⁶ die in Anspruch 1 genannte Bedeutung haben,
in Gegenwart wenigstens eines Reduktionsmittels mit Mo- oder W-Komplexen der allgemeinen Formel (C),
[M(NR³)(NR⁴)Cl₂L₂]
worin
M für W oder Mo steht
L für einen Liganden ausgewählt aus aliphatischen oder aromatischen Aminen, E- them, Halogenid, bevorzugt Chlorid, oder Nitrilen, bevorzugt Acetonitril,
R³ oder R⁴ die in Anspruch 1 genannte Bedeutung haben,
in einem geeigneten Lösungsmittel bevorzugt bei einer Temperatur von -20°C bis 120°C umgesetzt werden.

8. Verwendung von Verbindungen gemäß den Ansprüchen 1 bis 6 als Vorläuferverbindung (Prekursor) für die Herstellung Wolfram- bzw. Molybdän-haltiger Schichten mittels des Chemical Vapour Deposition-Verfahrens.

9. Verwendung gemäß Anspruch 8, **dadurch gekennzeichnet, dass** Wolfram- bzw. Molybdän-haltige Schichten Wolframnitrid-(WN)-schichten bzw. Molybdännitrid-(MoN)-schichten sind.

10. Wolfram- bzw. Molybdän-haltige Schichten hergestellt mittels des Chemical Vapour Deposition-Verfahrens unter Verwendung von Verbindungen gemäß den Ansprechen 1 bis 6 als Vorläuferverbindungen (Prekursoren).

11. Wolfram- bzw. Molybdän-haltige Schichten gemäß Anspruch 10, **dadurch gekennzeichnet, dass** es sich um Wolframnitrid-(WN)-schichten bzw. Molybdärmitrid-(MoN)-schichten handelt.

12. Substrate aufweisend eine Wolfram- bzw. Molybdän-haltige Schicht gemäß Anspruch 10 oder 11.

## Claims

1. Compounds of the general formula (I) 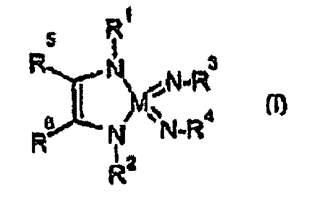 wherein
M represents W or Mo,
R¹ and R² independently of each other represent C₁- to C₁₂-alkyl, C₅- to C₁₂- cycloalkyl, C₆- to C₁₀-aryl radicals, 1-alkenyl, 2-alkenyl, 3-alkenyl radicals, triorganosilyl radicals -SiR₃ or amino radicals NR₂, wherein R represents a C₁- to C₄-alkyl radical,
R³ and R⁴ independently of each other represent a C₁- to C₈-alkyl, C₅- to C₁₀- cycloalkyl, C₆- to C₁₄-aryl radical, SiR₃ or NR₂, wherein R has the abovementioned meaning, and
R⁵ and R⁶ independently of each other represent H or a C₁- to C₁₂-alkyl, C₅- to C₁₂- cycloalkyl or C₆- to C₁₀-aryl radical.

2. Compounds according to claim 1, **characterized in that** R¹, R², R³, R⁴, R⁵ and R⁶ can each be substituted independently of each other by a C₁-C₄-alkoxy or di(C₁-C₄-alkyl)amino radical.

3. Compounds according to claim 1 or 2, **characterized in that** they correspond to the general formula (II) 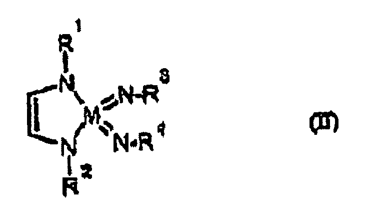 wherein
M, R¹ and R² have the meaning given in claim 1 and
R³ and R⁴ independently of each other represent a C₁- to C₅-alkyl radical, a C₅- to C₆- cycloalkyl radical, a C₆-C₁₀-aryl radical, SiR₃ or NR₂, wherein R represents C₁-C₄-alkyl.

4. Compounds according to claim 3, **characterized in that** the C₆-C₁₀ aryl radical in R³ and R⁴ can be substituted by one to three C₁-C₅-alkyl groups.

5. Compounds according to at least one of claims 1 to 4, **characterized in that** they correspond to the general formula (III) 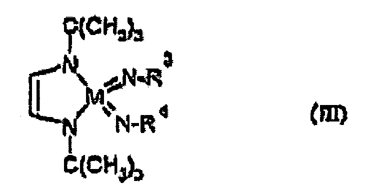 wherein M, R³ and R⁴ have the meaning given in claims 1 to 4.

6. Compounds according to at least one of claims 1 to 5, **characterized in that** they correspond to the general formula (IV) 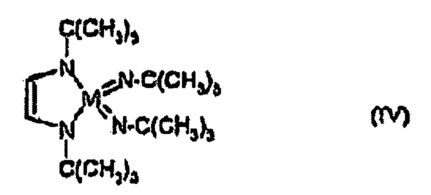 wherein M has the meaning given in claim 1.

7. Process for the preparation of compounds according to claims 1 to 6, **characterized in that** DAD ligand precursors of the general formula (B) 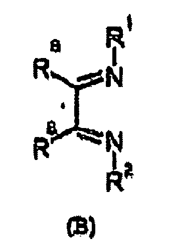 wherein R¹, R², R⁵ and R⁶ have the meaning given in claim 1,
are reacted in the presence of at least one reducing agent with Mo complexes or W complexes of the general formula (C)
[M(NR³)(NR⁴)Cl₂L₂]
wherein
M represents W or Mo
L represents a ligand chosen from aliphatic or aromatic amines, ethers, halide, preferably chloride, or nitriles, preferably acetonitrile,
R³ and R⁴ have the meaning given in claim 1,
in a suitable solvent, preferably at a temperature of from -20 °C to 120 °C.

8. Use of compounds according to claims 1 to 6 as a precursor compound for the preparation of tungsten- or molybdenum-containing layers by means of the chemical vapour deposition process.

9. Use according to claim 8, **characterized in that** tungsten- or molybdenum-containing layers are tungsten nitride (WN) layers or molybdenum nitride (MoN) layers.

10. Tungsten- or molybdenum-containing layers prepared by means of the chemical vapour deposition process using compounds according to claims 1 to 6 as precursor compounds.

11. Tungsten- or molybdenum-containing layers according to claim 10, **characterized in that** they are tungsten nitride (WN) layers or molybdenum nitride (MoN) layers.

12. Substrates comprising a tungsten- or molybdenum-containing layer according to claim 10 or 11.

## Revendications

1. Composés de la formule générale (I) 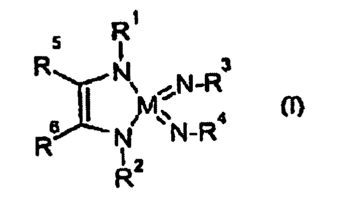 dans laquelle
M représente W ou Mo,
R¹ et R² représentent, indépendamment l'un de l'autre un radical alkyle en C₁ à C₁₂, un radical cycloalkyle en C₅ à C₁₂, un radical aryle en C₆ à C₁₀, un radical 1-alcényle, un radical 2-alcényle, un radical 3-alcényle, un radical triorganosilyle -SiR₃ ou un radical amino NR₂, dans lesquels R représente un radical alkyle en C₁ à C₄,
R³ et R⁴ représentent, indépendamment l'un de l'autre un radical alkyle en C₁ à C₈, un radical cycloalkyle en C₅ à C₁₀, un radical aryle en C₆ à C₁₄, SiR₃ ou NR₂, R ayant la signification énoncée ci-dessus, et
R⁵ et R⁶ représentent, indépendamment l'un de l'autre un radical alkyle en C₁ à C₁₂, un radical cycloalkyle en C₅ à C₁₂ ou un radical aryle en C₆ à C₁₀.

2. Composés selon la revendication 1, **caractérisés en ce que** R¹, R2, R³, R⁴, R⁵ et R⁶, peuvent être substitués indépendamment l'un de l'autre par un radical alcoxyle en C₁ à C₄ ou par un radical di(alkyle en C₁ à C₄)amino.

3. Composés selon la revendication 1 ou 2, **caractérisés en ce qu'**ils correspondent à la formule générale (II) 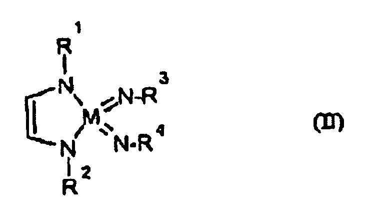 dans laquelle
M, R¹ et R² ont la signification énoncée dans la revendication 1 et R³ et R⁴ représentent, indépendamment l'un de l'autre un radical alkyle en C₁ à C₅, un radical cycloalkyle en C₅ à C₆, un radical aryle en C₆ à C₁₀, SiR₃ ou NR₂, R représentant un alkyle en C₁ à C₄.

4. Composés selon la revendication 3, **caractérisés en ce que** le radical aryle en C₆ à C₁₀ dans R³ et R⁴ peut être substitué par un à trois groupes alkyles en C₁ à C₅.

5. Composés selon l'une au moins des revendications 1 à 4, **caractérisés en ce qu'**ils correspondent à la formule générale (III) 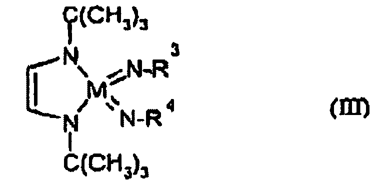 dans laquelle M, R³ et R⁴ ont la signification énoncée dans les revendications 1 à 4.

6. Composés selon l'une au moins des revendications 1 à 5, **caractérisés en ce qu'**ils correspondent à la formule générale (IV) 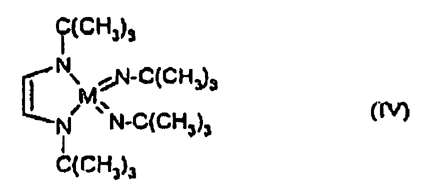 dans laquelle M a la signification énoncée dans la revendication 1.

7. Procédé pour la préparation de composés selon les revendications 1 à 6, **caractérisé en ce que** l'on fait réagir des précurseurs de ligand DAD de la formule générale (B) 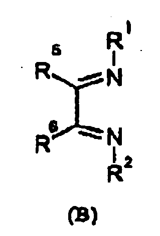 dans laquelle R¹, R², R⁵ et R⁶ ont la signification énoncée dans la revendication 1,
en présence d'au moins un réducteur avec des complexes de Mo ou de W de la formule générale (C),
[M(NR³)(NR⁴)Cl₂L₂]
dans laquelle
M représente W ou Mo,
L représente un ligand, choisi parmi des amines aliphatiques ou aromatiques, des éthers, des halogénures, de préférence des chlorures, ou des nitriles, de préférence de l'acétonitrile,
R³ ou R⁴ ont la signification énoncée dans la revendication 1, dans un solvant approprié, de préférence à une température de -20 °C à 120 °C.

8. Utilisation de composés selon les revendications 1 à 6 comme composés précurseurs pour la préparation de couches contenant du tungstène, respectivement du molybdène, au moyen du procédé « Chemical Vapour Deposition ».

9. Utilisation selon la revendication 8, **caractérisée en ce que** les couches contenant du tungstène, respectivement du molybdène, sont des couches de nitrure de tungstène (WN), respectivement de nitrure de molybdène (MoN).

10. Couches contenant du tungstène, respectivement du molybdène, fabriquées au moyen du procédé « Chemical Vapour Deposition » moyennant l'utilisation comme précurseurs de composés selon les revendications 1 à 6.

11. Couches contenant du tungstène ou du molybdène selon la revendication 10, **caractérisées en ce qu'**il s'agit de couches de nitrure de tungstène (WN), respectivement de couches de nitrure de molybdène (MoN).

12. Substrats comportant une couche contenant du tungstène, respectivement du molybdène selon la revendication 10 ou 11.
